# FASCICULE DE BREVET EUROPEEN

(11) **EP 3 532 653 B1**
(45) Date de publication et mention de la délivrance du brevet: **15.03.2023**
(21) Numéro de dépôt: 17794020.2
(22) Date de dépôt: 19.10.2017
(51) Int. Cl.: C23C 28/00, C23C 14/16, C23C 14/34, C23C 10/28

(54) **PIÈCE COMPRENANT UN SUBSTRAT EN SUPERALLIAGE MONOCRISTALLIN À BASE DE NICKEL ET SON PROCÉDÉ DE FABRICATION**
TEIL MIT EINEM SUBSTRAT AUS EINER MONOKRISTALLINEN SUPERLEGIERUNG AUF NICKELBASIS UND VERFAHREN ZUR HERSTELLUNG DAVON
PART COMPRISING A NICKEL-BASED MONOCRYSTALLINE SUPERALLOY SUBSTRATE AND METHOD FOR MANUFACTURING SAME

(30) Priorité: 27.10.2016 FR 1660417
(43) Date de publication de la demande: 04.09.2019
(73) Titulaire: Safran, 75015 Paris (FR)
(72) Inventeur: SABOUNDJI, Amar, 77550 Moissy-Cramayel (FR); JAQUET, Virginie, 77550 Moissy-Cramayel (FR); RAME, Jérémy, 77550 Moissy-Cramayel (FR)
(74) Mandataire: Regimbeau
(86) Numéro de dépôt international: PCT/FR2017/052880
(87) Numéro de publication internationale: WO 2018/078246

(56) Documents cités:
- EP-A1- 1 191 125
- EP-A2- 1 528 118

## Description

### DOMAINE TECHNIQUE GENERAL

L'invention se situe dans le domaine des superalliages monocristallins à base de nickel.

La présente invention concerne plus précisément un procédé de fabrication d'une pièce comprenant un substrat en superalliage monocristallin à base de nickel, ainsi qu'une pièce comprenant un substrat en superalliage monocristallin à base de nickel.

### ETAT DE L'ART

Par "superalliages", on entend des alliages complexes présentant, à haute température et à haute pression, une très bonne résistance à l'oxydation, à la corrosion, au fluage et à des contraintes cycliques (notamment mécaniques ou thermiques). Ces superalliages trouvent une application particulière dans la fabrication de pièces utilisées dans l'aéronautique, par exemple des aubes de turbine.

On connaît déjà dans l'état de la technique, des pièces qui comprennent successivement de l'intérieur vers l'extérieur : un substrat en superalliage monocristallin à base de nickel, une ou plusieurs sous-couche(s) et une barrière thermique.

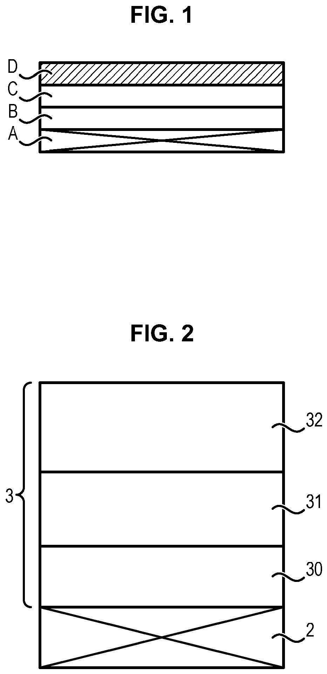

Sur la figure 1 jointe, on peut voir une représentation schématique et en coupe d'un exemple d'une telle pièce. Celle-ci comprend successivement un substrat A en superalliage monocristallin à base de nickel, une sous-couche B d'un alliage choisi parmi NiAlPt, MCrAlY avec M égal à Co et/ou Ni, une couche C d'un oxyde, par exemple de l'alumine et enfin une barrière thermique D.

De nombreuses études ont montré qu'une interdiffusion des composants chimiques entre un superalliage et son revêtement, ainsi que l'oxydation des joints de grains de la couche d'alumine par diffusion de l'oxygène, pouvaient avoir des conséquences néfastes sur la durée de vie de la pièce.

Lorsque la pièce précitée est par exemple une aube de turbine, utilisée à des températures comprises entre 800°C et 1600°C, on constate que l'interdiffusion est importante entre le superalliage du substrat et les différentes couches qui le recouvrent, du fait de leurs différences de compositions chimiques. A titre d'exemple, l'aluminium de la sous-couche B peut diffuser vers le substrat A ou le titane du substrat peut diffuser vers la sous-couche B. Les flux de diffusion associés à ce phénomène peuvent avoir différentes conséquences.

Tout d'abord, les flux précités entraînent l'appauvrissement prématuré de la couche C d'alumine, ce qui favorise la transformation martensitique de la sous-couche B (phase β-NiAl transformée en phase γ'-Ni3Al,). Ces transformations génèrent des fissures et favorisent l'écaillage de la couche d'oxyde.

Ensuite, la diffusion de certains éléments du superalliage, comme le titane, ou de certaines impuretés, comme le soufre, va dégrader l'adhérence entre la couche d'oxyde C et la barrière thermique D.

D'autre part, l'interdiffusion peut entraîner la formation des zones de réaction secondaire (connues sous l'acronyme anglais de SRZ : "Secondary Reaction Zones") qui vont fortement dégrader les propriétés mécaniques (de fluage, de résistance à la fatigue) du superalliage revêtu.

Enfin, lorsque la pièce précitée est une aube de turbine, des gaz chauds issus de la chambre de combustion (surtout de l'oxygène) diffusent au travers de la barrière thermique poreuse jusqu'à atteindre la couche d'alumine. Ceci conduit à une oxydation des joints de grains de la couche d'alumine et à un gonflement de cette dernière. Cette évolution s'accompagne de contraintes de compression à long terme dues à la croissance des joints de grains, ce qui conduit à des ondulations de surface de la sous-couche B (ondulations connues sous la terminologie anglaise de "rumpling") et à une perte d'adhérence (écaillage) de la barrière thermique D. Il est intéressant de noter que ce phénomène est encore accru dans le cas où la sous-couche B est sous forme d'une phase β-(Ni,Pt)Al, car la différence de composition entre cette sous-couche B et le superalliage du substrat A est importante.

Afin de limiter les conséquences néfastes de l'interdiffusion et d'augmenter la durée de vie des superalliages revêtus, on connaît déjà d'après l'état de la technique, une solution consistant à intercaler une barrière de diffusion, d'une épaisseur de quelques micromètres, entre le substrat A en superalliage et la sous-couche B.

Cette barrière de diffusion est constituée par exemple d'une couche dense d'alumine ou d'un alliage à base de rhénium et l'on a pu constater que la diffusion de certains éléments du superalliage du substrat A (tels que le titane ou le soufre par exemple) est ralentie dans cette barrière de diffusion.

Cependant, l'emploi de cette barrière de diffusion réduit la résistance mécanique en fatigue thermique, de la pièce, compte tenu des différences de coefficients de dilatation thermique entre la barrière de diffusion, la sous-couche B et le substrat A. De plus, l'initiation de fissures est accentuée au niveau de la barrière de diffusion lors de sollicitations en fatigue mécanique.

On connaît également d'après le document EP 1 191 125, un procédé de fabrication d'une pièce comprenant un substrat en superalliage monocristallin à base de nickel. Le procédé consiste à former sur ce substrat un revêtement comprenant une structure multicouches comprenant de l'aluminium et du platine et à recouvrir ce revêtement d'une couche d'alumine.

### PRESENTATION DE L'INVENTION

L'invention a donc pour objectif de proposer une solution technique pour obtenir un substrat en superalliage monocristallin à base de nickel recouvert d'un revêtement et d'un couche d'alumine, et ceci :
- tout en limitant les phénomènes d'interdiffusion entre le substrat en superalliage et les couches dudit revêtement, sans dégrader les propriétés mécaniques du superalliage ;
- en limitant l'oxydation des joints de grains de la couche d'alumine ;
- et, en améliorant la durée de vie du système complet (substrat revêtu).

Lorsque la couche d'alumine est en outre revêtue d'une barrière thermique, un autre objectif de l'invention est d'améliorer l'adhérence entre la couche d'alumine et la barrière thermique.

A cet effet, l'invention concerne un procédé de fabrication d'une pièce comprenant un substrat en superalliage monocristallin à base de nickel.

Conformément à l'invention, ce procédé comprend les étapes consistant à :
- fabriquer un substrat en superalliage monocristallin à base de nickel,
- former sur ledit substrat, un revêtement comprenant au moins une couche d'un premier type comprenant de l'aluminium et du platine, au moins une couche d'un deuxième type comprenant de l'aluminium, du silicium et du platine et une couche d'un troisième type comprenant du nickel, de l'aluminium, du silicium et du platine, cette couche de troisième type étant située la plus à l'extérieur de l'empilement de couches du revêtement,
- former une couche d'alumine dopée au silicium sur ladite couche de troisième type.

Grâce à ces caractéristiques de l'invention, les différentes couches du revêtement limitent les phénomènes d'interdiffusion entre le superalliage du substrat et la couche d'alumine, et ce, sans dégrader les propriétés mécaniques de ces superalliages.

Par ailleurs, le silicium diffuse dans la couche d'alumine qui constitue ainsi une barrière de diffusion efficace vis-à-vis de l'oxygène de l'atmosphère extérieure.

Enfin, la durée de vie de la pièce obtenue par ce procédé est améliorée.

Selon d'autres caractéristiques avantageuses et non limitatives de l'invention, prises seules ou en combinaison :
- ledit revêtement comprend au moins trois couches de premier type ;
- ledit revêtement comprend deux couches de deuxième type ;
- ledit revêtement comprend une succession de couches du premier type et/ou une succession de couches de deuxième type ;
- dans ledit revêtement, la couche située au contact du substrat en superalliage monocristallin à base de nickel est une couche de premier type ;

- au moins l'une des couches parmi la couche de premier type, la couche de deuxième type et la couche de troisième type est formée :
   - pour ladite couche de premier type par dépôt d'une couche nanocristalline d'aluminium puis d'une couche nanocristalline de platine ou l'inverse,
   - pour ladite couche de deuxième type par dépôt dans un ordre quelconque d'une couche nanocristalline d'aluminium, d'une couche nanocristalline de platine et d'une couche nanocristalline de silicium,
   - et pour ladite couche de troisième type par dépôt dans un ordre quelconque d'une couche nanocristalline d'aluminium, d'une couche nanocristalline de platine, d'une couche nanocristalline de nickel et d'une couche nanocristalline de silicium,
      et lesdites couches nanocristallines sont soumises à un traitement de diffusion, de façon à former ledit revêtement ;
   - le dépôt des différentes couches du revêtement est réalisé par dépôt physique en phase vapeur ou par dépôt chimique en phase vapeur ;
   - le dépôt des différentes couches du revêtement est réalisé par pulvérisation cathodique.
   - il comprend une étape supplémentaire consistant à déposer une barrière thermique sur ladite couche d'alumine dopée au silicium.

L'invention concerne également une pièce comprenant un substrat en superalliage monocristallin à base de nickel.

Conformément à l'invention, la pièce comprend successivement sur ledit substrat, un revêtement recouvert d'une couche d'alumine dopée au silicium, ledit revêtement comprenant au moins une couche d'un premier type comprenant de l'aluminium et du platine, au moins une couche d'un deuxième type comprenant de l'aluminium, du silicium et du platine et une couche d'un troisième type comprenant du nickel, de l'aluminium, du silicium et du platine, cette couche de troisième type étant située la plus à l'extérieur de l'empilement de couches du revêtement.

De façon avantageuse, ladite couche d'alumine dopée au silicium est recouverte d'une barrière thermique.

### PRESENTATION DES FIGURES

D'autres caractéristiques et avantages de l'invention apparaîtront de la description qui va maintenant en être faite, en référence aux dessins annexés, qui en représentent, à titre indicatif mais non limitatif, un mode de réalisation possible.

Sur ces dessins :
- la figure 1 est une vue schématique et en coupe, d'une pièce conforme à l'état de la technique comprenant un substrat en superalliage monocristallin à base de nickel recouvert de plusieurs couches, et
- la figure 2 est une vue schématique et en coupe d'un substrat (2), recouvert d'un revêtement (3), ce revêtement (3) étant conforme à un mode de réalisation de l'invention,
- la figure 3 est une vue schématique et en coupe d'un substrat (2), recouvert d'un revêtement (3), ce revêtement (3) étant conforme à un autre mode de réalisation de l'invention,
- la figure 4 est une vue schématique et en coupe du détail des différentes couches déposées pour former le revêtement (3) du substrat (2) selon un mode de réalisation particulier,
- la figure 5 est une vue schématique et en coupe de deux modes de réalisation d'une pièce (1, 1') pièce conforme à l'invention, comprenant un substrat (2) et un revêtement (3) recouvert d'une couche d'alumine dopée (4) et éventuellement d'une barrière thermique (5).

### DESCRIPTION DETAILLEE

Le procédé de fabrication d'une pièce conforme à l'invention va maintenant être décrit.

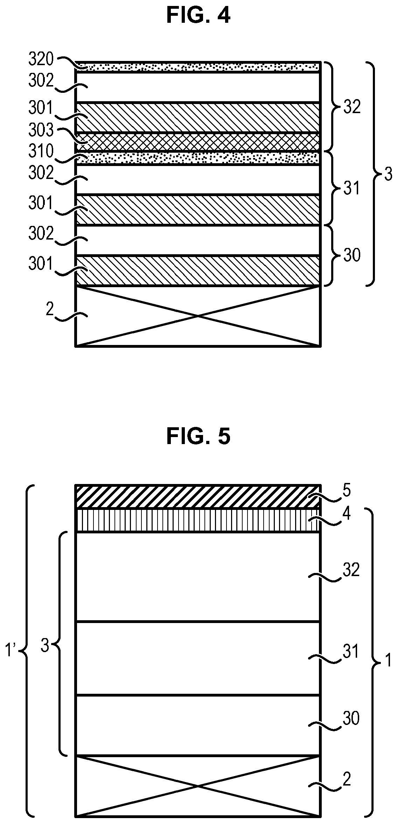

Selon un premier mode de réalisation de l'invention représenté sur la figure 5, la pièce finie, référencée 1, comprend un substrat 2, recouvert d'un revêtement 3 multicouches, lui-même recouvert d'une couche d'alumine 4.

Selon un deuxième mode de réalisation de l'invention représenté sur cette même figure, la couche d'alumine 4 est recouverte d'une couche de barrière thermique 5. La pièce finie est alors référencée 1'.

Le substrat 2 est réalisé en un superalliage monocristallin à base de nickel.

Ce substrat est par exemple obtenu par fonderie ou par fabrication additive et présente la forme finale souhaitée, par exemple celle d'une aube de turbine.

A titre d'exemples purement illustratifs, on peut citer comme superalliages susceptibles d'être utilisés pour la fabrication du substrat 2 ceux mentionnés dans le tableau 1 ci-dessous. Ils sont identifiés par les lettres A à F. D'autres superalliages monocristallins à base de nickel peuvent également être utilisés.

**Tableau 1**

| Exemples de superalliages monocristallins à base de nickel | | | | | | | | | | | |
|---|---|---|---|---|---|---|---|---|---|---|---|
| | **Eléments alliages (pourcentages massiques)** | | | | | | | | | | |
| | **Ni** | **Al** | **Co** | **Cr** | **Mo** | **Re** | **Ta** | **Ti** | **W** | **Cb** | **Ru** |
| A | Reste | 5,2 | 6,5 | 7,8 | 2 | 0 | 7,9 | 1,1 | 5,7 | | |
| B | Reste | 5,6 | 9,6 | 6,5 | 0,6 | 3 | 6,5 | 1 | 6 | | |
| C | Reste | 5,73 | 9,6 | 3,46 | 0,6 | 4,87 | 8,28 | 0,86 | 5,5 | | |
| D | Reste | 5,7 | 3 | 2 | 0,4 | 6 | 8 | 0,2 | 5 | 0,1 | |
| E | Reste | 5,8 | 12,5 | 4,2 | 1,4 | 5,4 | 7,2 | 0 | 6 | | |
| F | Reste | 6 | <0,2 | 4 | 1 | 4 | 5 | 0,5 | 5 | | 4 |

Le terme "reste" correspond, pour chaque superalliage, au pourcentage massique résiduel pour atteindre 100% avec les différents autres composants mentionnés.

Comme on peut le voir sur la figure 2, le revêtement 3, formé sur le substrat 2 comprend au moins une couche 30 comprenant de l'aluminium et du platine, dite "couche d'un premier type", au moins une couche 31 comprenant de l'aluminium, du silicium et du platine, dite "couche d'un deuxième type" et une couche 32 comprenant du nickel, de l'aluminium, du silicium et du platine, dite "couche d'un troisième type". La couche de troisième type 32 est située la plus à l'extérieur de l'empilement de couches du revêtement 3. En d'autres termes, c'est la plus éloignée du substrat 2.

De préférence, le revêtement 3 comprend au moins trois couches de premier type. De préférence également, le revêtement 3 comprend deux couches de deuxième type 31. Les différentes couches 30 et 31 peuvent être alternées mais ceci n'est pas obligatoire.

Il est également possible d'avoir une succession de couches 30 du premier type et/ou une succession de couches 31 du deuxième type.

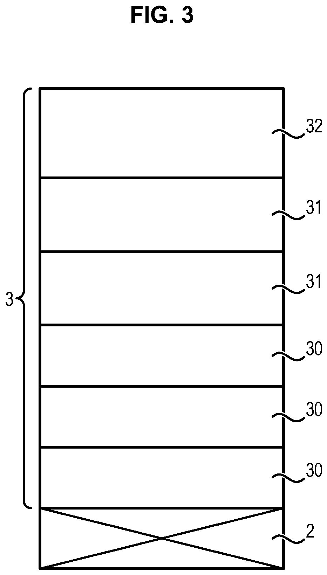

Ainsi, par exemple sur la figure 3, qui illustre une autre variante de réalisation, le revêtement 3 comprend trois couches de premier type 30 successives puis deux couches de deuxième type 31 successives et enfin une couche de troisième type 32.

De préférence, la couche située au contact du substrat 2 est une couche du premier type 30.

De façon avantageuse, les différentes couches constitutives du revêtement 3 sont réalisées sur le même bâti de dépôt. Elles peuvent être déposées par différents procédés de dépôt physique en phase vapeur (PVD) ou de dépôt chimique en phase vapeur (CVD).

Parmi les dépôts physiques en phase vapeur, on peut citer l'emploi du dépôt physique en phase vapeur par faisceau d'électrons (EBPVD pour *"electron beam chemical vapor deposition"*), l'évaporation, l'ablation par laser pulsé ou la pulvérisation cathodique. Cette dernière technique est utilisée de préférence. Elle a l'avantage de permettre la formation de films denses, d'une épaisseur nanométrique ou micrométrique et qui présentent une adhérence sur la couche précédente supérieure à celle obtenue avec les autres techniques de dépôt.

Parmi les techniques de dépôts chimiques en phase vapeur (CVD), on peut citer par exemple :
- le dépôt chimique en phase vapeur assisté par plasma (PECVD pour *"plasma enhanced chemical vapor deposition"*),
- le dépôt chimique en phase vapeur à basse pression (LPCVD pour *"low pressure chemical vapor deposition"*),
- le dépôt chimique en phase vapeur sous ultravide (UHVCVD pour *"ultra high vacuum chemical vapor deposition"*),
- le dépôt chimique en phase vapeur à la pression atomique (APCVD pour *"atmospheric pressure chemical vapor deposition"*), et
- le dépôt chimique en phase vapeur de couches atomiques (ALCVD pour *"atomic layer chemical vapor deposition"*).

On notera toutefois que le dépôt de platine ne peut se faire que par dépôt PVD ou par électrodéposition.

Selon un premier mode de réalisation, au moins l'une des couches 30, 31, 32 du revêtement 3 est formée par co-dépôt des différents éléments chimiques constitutifs de cette couche.

Ce co-dépôt peut ainsi être effectué par exemple à partir d'une unique cible alliée comprenant les différents éléments chimiques constitutifs de ladite couche à former. Par exemple, pour former la couche de deuxième type 31, on peut utiliser une cible alliée comprenant de l'aluminium, du platine et du silicium.

Ce co-dépôt peut aussi être effectué par exemple à partir de plusieurs cibles différentes comprenant chacune l'un des éléments chimiques constitutifs de la couche à former. Par exemple, pour former la couche de troisième type 32, on peut utiliser simultanément quatre cibles, à savoir une cible en aluminium, une cible en nickel, une cible en silicium et une cible en platine (ou en chrome).

Quel que soit le type de co-dépôt choisi, cette technique permet d'obtenir les couches 30, 31 et 32 sous forme d'alliages, (respectivement un alliage Al/Pt pour la couche de premier type 30, un alliage Al/Pt/Si pour la couche de deuxième type 31 et un alliage Al/Pt/Si/Ni pour la couche de troisième type 32.

Selon un deuxième mode de réalisation de l'invention, représenté sur la figure 4, il est également possible de former les différentes couches du revêtement 3 de la façon suivante.

Pour la couche de premier type 30, on procède au dépôt d'une couche nanocristalline de platine 301, puis d'une couche nanocristalline d'aluminium 302 ou l'inverse.

Pour la couche de deuxième type 31, on procède au dépôt, dans un ordre quelconque, d'une couche nanocristalline d'aluminium 302, d'une couche nanocristalline de platine 301 et d'une couche nanocristalline de silicium 310.

Enfin, pour la couche de troisième type 32 on procède au dépôt, dans un ordre quelconque, d'une couche nanocristalline d'aluminium 302, d'une couche nanocristalline de platine 301, d'une couche nanocristalline de nickel 303 et d'une couche nanocristalline de silicium 320.

Le terme « nanocristalline » signifie que les cristaux (grains) qui constituent ces couches de matériau polycristallin sont d'une dimension inférieure à 1 micromètre (1µm).

De façon avantageuse, les deux couches de silicium 310, 320 présentent une épaisseur inférieure à 100 nm. De préférence, la couche 303 de nickel présente une épaisseur inférieure à 100nm.

De façon avantageuse également, les couches 301 de platine et/ou les couches 302 d'aluminium présentent une épaisseur inférieure à 1 micromètre (1µm).

Une fois les différentes couches du revêtement 3 formées, on procède à un traitement de diffusion, par chauffage à une température comprise de préférence entre 200°C et 1200°C.

On notera qu'après le traitement de diffusion, les couches 30, 31, 32 obtenues restent nanocristallines.

On procède ensuite à la formation de la couche d'alumine 4, sur la couche de troisième type 32. Pour ce faire, de préférence, on soumet le substrat 2 recouvert du revêtement 3 à un traitement thermique, sous pression partielle d'oxygène, ou d'oxygène et d'argon.

De façon avantageuse, ce traitement thermique comprend une étape de montée en température jusqu'à atteindre une température comprise entre 900°C et 1200°C, une étape de maintien de cette température pendant moins d'une heure et une étape de refroidissement jusqu'à atteindre la température ambiante.

Enfin, lorsque l'on souhaite obtenir le substrat 1', on dépose la barrière thermique 5 sur la couche d'alumine 4.

Cette barrière thermique est par exemple une couche de zircone yttriée ou une alternance d'au moins une couche de zircone yttriée (contenant de l'yttrium) et d'au moins une couche de céramique.

De préférence, ladite barrière thermique 5 est déposée par dépôt physique en phase vapeur par faisceau d'électrons (EBPVD).

Les rôles des différentes couches sont les suivantes.

Les couches 301 de platine et 302 d'aluminium sont nanocristallines, ce qui permet d'augmenter la surface totale des joints de grains qui forment ainsi une bonne barrière de diffusion, pour limiter les interdiffusions entre le superalliage du substrat 2 et son revêtement 3. En outre, les joints de grains de ces couches de platine et d'aluminium limitent également la corrosion et l'oxydation du substrat 2.

Un autre avantage résultant du fait que le revêtement 3 comprend de très nombreuses couches est la multiplication du nombre d'interfaces. Ces interfaces sont de potentiels chemins de blocage de l'oxygène et d'autres métaux et elles limitent ainsi les phénomènes d'interdiffusion entre le substrat 2 et la couche d'alumine 4. Le revêtement 3 multicouches augmente ainsi la ténacité de l'ensemble de la pièce 1 ou 1'.

Un autre avantage d'un revêtement 3 multicouches réside dans son mécanisme d'usure. A chaque interface entre deux couches successives, il existe des contraintes de compression et de tension. Ainsi les fissures qui peuvent apparaître se propagent préférentiellement le long des interfaces plutôt que perpendiculairement aux couches. Du fait du grand nombre d'interfaces, la durée de vie de la pièce 1 ou 1' est augmentée.

Enfin, la multiplication des couches du revêtement 3 permet d'une part, d'associer différents types de matériau de revêtement et d'autre part, d'augmenter l'étanchéité globale du revêtement 3 en cas de défaut et/ou de fissuration de certaines de ses couches.

Par ailleurs, chaque couche 31, 32 qui contient du silicium, a un rôle bien particulier.

Une partie du silicium de la couche de troisième type 32, diffuse d'une part dans les joints de grains de la couche d'alumine 4 contiguë et d'autre part, dans l'autre couche qui lui est contiguë, à savoir la couche d'aluminium 302 ou la couche de platine 301 suivant l'ordre dans lequel elles ont été déposées.

Dans les conditions d'utilisation des aubes de turbines, c'est-à-dire dans une gamme de température allant de 800°C à 1600°C, le silicium se trouvant dans les joints de grains de l'alumine réagit avec les gaz chauds produits dans la chambre de combustion de l'aéronef, tels que de l'oxygène et/ou de l'azote pour former de l'oxyde de silicium (SiO₂) et/ou du nitrure de silicium (Si₃N₄).

Cet oxyde de silicium et ce nitrure constituent une barrière de diffusion très efficace vis-à-vis de l'oxygène car leurs coefficients de diffusion sont relativement faibles.

En diffusant dans les joints de grains de la couche d'alumine 4, le silicium freine ainsi l'oxydation de la couche d'alumine, augmente la durée de vie de celle-ci et ainsi la durée de vie de l'ensemble de la pièce 1, 1'.

Le silicium de la couche de deuxième type 31 sert quant à lui de réservoir au silicium de la couche de troisième type 32, dans le cas où celui-ci viendrait à être totalement consommé. Lorsqu'il y a plusieurs couches 31, le silicium de celles-ci joue le même rôle.

## Revendications

1. Procédé de fabrication d'une pièce (1) comprenant un substrat (2) en superalliage monocristallin à base de nickel, **caractérisé en ce qu'**il comprend les étapes consistant à :
- fabriquer un substrat (2) en superalliage monocristallin à base de nickel,
- former sur ledit substrat (2), un revêtement (3) comprenant au moins une couche (30) d'un premier type comprenant de l'aluminium et du platine, au moins une couche (31) d'un deuxième type comprenant de l'aluminium, du silicium et du platine et une couche (32) d'un troisième type comprenant du nickel, de l'aluminium, du silicium et du platine, cette couche de troisième type (32) étant située la plus à l'extérieur de l'empilement de couches du revêtement (3),
- former une couche (4) d'alumine dopée au silicium sur ladite couche de troisième type (32).

2. Procédé selon la revendication 1, **caractérisé en ce que** ledit revêtement (3) comprend au moins trois couches de premier type (30).

3. Procédé selon la revendication 1 ou 2, **caractérisé en ce que** ledit revêtement (3) comprend deux couches de deuxième type (31).

4. Procédé selon l'une des revendications précédentes, **caractérisé en ce que** ledit revêtement (3) comprend une succession de couches du premier type (30) et/ou une succession de couches de deuxième type (31).

5. Procédé selon l'une des revendications précédentes, **caractérisé en ce que** dans ledit revêtement (3), la couche située au contact du substrat (2) en superalliage monocristallin à base de nickel est une couche de premier type (30).

6. Procédé selon l'une des revendications précédentes, **caractérisée en ce qu'**au moins l'une des couches parmi la couche de premier type (30), la couche de deuxième type (31) et la couche de troisième type (32) est formée :
- pour ladite couche de premier type (30) par dépôt d'une couche nanocristalline d'aluminium (302) puis d'une couche nanocristalline de platine (301) ou l'inverse,
- pour ladite couche de deuxième type (31) par dépôt dans un ordre quelconque d'une couche nanocristalline d'aluminium (302), d'une couche nanocristalline de platine (301) et d'une couche nanocristalline de silicium (310),
- et pour ladite couche de troisième type (32) par dépôt dans un ordre quelconque d'une couche nanocristalline d'aluminium (302), d'une couche nanocristalline de platine (301), d'une couche nanocristalline de nickel (303) et d'une couche nanocristalline de silicium (320),
et **en ce que** lesdites couches nanocristallines (301, 302, 303, 310, 320) sont soumises à un traitement de diffusion, de façon à former ledit revêtement (3).

7. Procédé selon l'une des revendications précédentes, **caractérisé en ce que** le dépôt des différentes couches du revêtement (3) est réalisé par dépôt physique en phase vapeur ou par dépôt chimique en phase vapeur.

8. Procédé selon la revendication 7, **caractérisé en ce que** le dépôt des différentes couches du revêtement (3) est réalisé par pulvérisation cathodique.

9. Procédé selon l'une des revendications précédentes, l'une des revendications précédentes, **caractérisé en ce qu'**il comprend une étape supplémentaire consistant à déposer une barrière thermique (5) sur ladite couche (4) d'alumine dopée au silicium.

10. Pièce (1) comprenant un substrat (2) en superalliage monocristallin à base de nickel, **caractérisée en ce qu'**elle comprend successivement sur ledit substrat (2), un revêtement (3) recouvert d'une couche (4) d'alumine dopée au silicium, ledit revêtement (3) comprenant au moins une couche (30) d'un premier type comprenant de l'aluminium et du platine, au moins une couche (31) d'un deuxième type comprenant de l'aluminium, du silicium et du platine et une couche (32) d'un troisième type comprenant du nickel, de l'aluminium, du silicium et du platine, cette couche de troisième type (32) étant située la plus à l'extérieur de l'empilement de couches du revêtement (3).

11. Pièce selon la revendication 10, **caractérisé en ce que** ladite couche (4) d'alumine dopée au silicium est recouverte d'une barrière thermique (5).

## Patentansprüche

1. Verfahren zur Herstellung eines Teils (1), das ein Substrat (2) aus monokristalliner Superlegierung auf Nickelbasis umfasst, **dadurch gekennzeichnet, dass** es die folgenden Schritte umfasst:
- Herstellen eines Substrats (2) aus monokristalliner Superlegierung auf Nickelbasis,
- Ausbilden einer Beschichtung (3) auf dem Substrat (2), die mindestens eine Schicht (30) eines ersten Typs, die Aluminium und Platin umfasst, mindestens eine Schicht (31) eines zweiten Typs, die Aluminium, Silicium und Platin umfasst und eine Schicht (32) eines dritten Typs umfasst, die Nickel, Aluminium, Silicium und Platin umfasst, wobei sich diese Schicht des dritten Typs (32) am weitesten außen am Stapel der Schichten der Beschichtung (3) befindet,
- Ausbilden einer siliciumdotierten Aluminiumoxidschicht (4) auf der Schicht des dritten Typs (32).

2. Verfahren nach Anspruch 1, **dadurch gekennzeichnet, dass** die Beschichtung (3) mindestens drei Schichten des ersten Typs (30) umfasst.

3. Verfahren nach Anspruch 1 oder 2, **dadurch gekennzeichnet, dass** die Beschichtung (3) zwei Schichten des zweiten Typs (31) umfasst.

4. Verfahren nach einem der vorangehenden Ansprüche, **dadurch gekennzeichnet, dass** die Beschichtung (3) eine Abfolge von Schichten des ersten Typs (30) und/oder eine Abfolge von Schichten des zweiten Typs (31) umfasst.

5. Verfahren nach einem der vorangehenden Ansprüche, **dadurch gekennzeichnet, dass** in der Beschichtung (3) die Schicht, die sich im Kontakt mit dem Substrat (2) aus monokristalliner Superlegierung auf Nickelbasis befindet, eine Schicht des ersten Typs (30) ist.

6. Verfahren nach einem der vorangehenden Ansprüche, **dadurch gekennzeichnet, dass** mindestens eine der Schichten von der Schicht des ersten Typs (30), der Schicht des zweiten Typs (31) und der Schicht des dritten Typs (32) gebildet ist:
- für die Schicht des ersten Typs (30) durch Aufbringen einer nanokristallinen Aluminiumschicht (302) dann einer nanokristallinen Platinschicht (301) oder umgekehrt,
- für die Schicht des zweiten Typs (31) durch Aufbringen einer nanokristallinen Aluminiumschicht (302), einer nanokristallinen Platinschicht (301) und einer nanokristallinen Siliciumschicht (310) in einer beliebigen Reihenfolge,
- und für die Schicht des dritten Typs (32) durch Aufbringen einer nanokristallinen Aluminiumschicht (302), einer nanokristallinen Platinschicht (301), einer nanokristallinen Nickelschicht (303) und einer nanokristallinen Siliciumschicht (320) in einer beliebigen Reihenfolge,
und dass die nanokristallinen Schichten (301, 302, 303, 310, 320) einer Diffusionsbehandlung unterzogen werden, um die Beschichtung (3) zu bilden.

7. Verfahren nach einem der vorangehenden Ansprüche, **dadurch gekennzeichnet, dass** das Aufbringen der verschiedenen Schichten der Beschichtung (3) durch physikalisches Aufbringen in der Dampfphase oder durch chemisches Aufbringen in der Dampfphase durchgeführt wird.

8. Verfahren nach Anspruch 7, **dadurch gekennzeichnet, dass** das Aufbringen der verschiedenen Schichten der Beschichtung (3) durch Kathodenzerstäubung durchgeführt wird.

9. Verfahren nach einem der vorangehenden Ansprüche, **dadurch gekennzeichnet, dass** es einen zusätzlichen Schritt umfasst, der darin besteht, eine thermische Barriere (5) auf die siliciumdotierte Aluminiumoxidschicht (4) aufzubringen.

10. Teil (1), das ein Substrat (2) aus monokristalliner Superlegierung auf Nickelbasis umfasst, **dadurch gekennzeichnet, dass** es aufeinanderfolgend auf dem Substrat (2) eine mit einer siliciumdotierten Aluminiumoxidschicht (4) bedeckte Beschichtung (3) umfasst, wobei die Beschichtung (3) mindestens eine Schicht (30) eines ersten Typs, die Aluminium und Platin umfasst, mindestens eine Schicht (31) eines zweiten Typs, die Aluminium, Silicium und Platine umfasst und eine Schicht (32) eines dritten Typs umfasst, die Nickel, Aluminium, Silicium und Platin umfasst, wobei sich diese Schicht des dritten Typs (32) am weitesten außen am Stapel der Schichten der Beschichtung (3) befindet.

11. Teil nach Anspruch 10, **dadurch gekennzeichnet, dass** die siliciumdotierte Aluminiumoxidschicht (4) mit einer thermischen Barriere (5) bedeckt ist.

## Claims

1. A process for manufacturing a part (1) comprising a nickel-based single-crystal superalloy substrate (2), **characterized in that** it comprises the steps consisting in:
- manufacturing a nickel-based single-crystal superalloy substrate (2),
- forming, on said substrate (2), a coating (3) comprising at least one layer (30) of a first type comprising aluminium and platinum, at least one layer (31) of a second type comprising aluminium, silicon and platinum and a layer (32) of a third type comprising nickel, aluminium, silicon and platinum, this third-type layer (32) being furthest outside the layer stack of the coating (3),
- forming a silicon-doped alumina layer (4) on said third-type layer (32).

2. The process according to claim 1, **characterized in that** said coating (3) comprises at least three first-type layers (30).

3. The process according to claim 1 or 2, **characterized in that** said coating (3) comprises two second-type layers (31).

4. The process according to one of the preceding claims, **characterized in that** said coating (3) comprises a succession of first-type layers (30) and/or a succession of second-type layers (31).

5. The process according to one of the preceding claims, **characterized in that** in said coating (3), the layer in contact with the nickel-based single-crystal superalloy substrate (2) is a first-type layer (30).

6. The process according to one of the preceding claims, **characterized in that** at least one of the layers among the first-type layer (30), the second-type layer (31) and the third-type layer (32) is formed:
- for said first-type layer (30) by depositing a nanocrystalline layer of aluminium (302) and then a nanocrystalline layer of platinum (301), or vice versa,
- for said second-type layer (31) by depositing, in any order, a nanocrystalline layer of aluminium (302), a nanocrystalline layer of platinum (301) and a nanocrystalline layer of silicon (310),
- and for said third-type layer (32) by depositing, in any order, a nanocrystalline layer of aluminium (302), a nanocrystalline layer of platinum (301), a nanocrystalline layer of nickel (303) and a nanocrystalline layer of silicon (320),
and **in that** said nanocrystalline layers (301, 302, 303, 310, 320) are subjected to a diffusion treatment, so as to form said coating (3).

7. The process according to one of the preceding claims, **characterized in that** the deposition of the different layers of the coating (3) is carried out by physical vapour deposition or chemical vapour deposition.

8. The process according to claim 7, **characterized in that** the deposition of the individual layers of the coating (3) is carried out by cathode sputtering.

9. The process according to one of the preceding claims, **characterized in that** it comprises an additional step consisting in depositing a thermal barrier (5) on said silicon-doped alumina layer (4).

10. A part (1) comprising a nickel-based single-crystal superalloy substrate (2), **characterized in that** it comprises successively on said substrate (2), a coating (3) covered with a silicon-doped alumina layer (4), said coating (3) comprising at least one layer (30) of a first type comprising aluminium and platinum, at least one layer (31) of a second type comprising aluminium, silicon and platinum and a layer (32) of a third type comprising nickel, aluminium, silicon and platinum, this third-type layer (32) being located furthest outside the layer stack of the coating (3).

11. The part according to claim 10, **characterized in that** said silicon-doped alumina layer (4) is covered with a thermal barrier (5).
